# EUROPÄISCHE PATENTSCHRIFT

(11) **EP 0 840 810 B1**
(45) Veröffentlichungstag und Bekanntmachung des Hinweises auf die Patenterteilung: **23.06.1999**
(21) Anmeldenummer: 96924741.0
(22) Anmeldetag: 17.07.1996
(51) Int. Cl.: C30B 7/00, C30B 7/10, C01B 31/36

(54) **VERFAHREN ZUM HERSTELLEN VON SILICIUMCARBID-EINKRISTALLEN**
PROCESS FOR PRODUCING SILICON CARBIDE MONOCRYSTALS
PROCEDE DE PRODUCTION DE MONOCRISTAUX DE CARBURE DE SILICIUM

(30) Priorität: 27.07.1995 DE 19527536
(43) Veröffentlichungstag der Anmeldung: 13.05.1998
(73) Patentinhaber: SIEMENS AKTIENGESELLSCHAFT, 80333 München (DE)
(72) Erfinder: STEIN, René, D-91341 Röttenbach (DE); RUPP, Roland, D-91207 Lauf (DE); VÖLKL, Johannes, D-91056 Erlangen (DE)
(86) Internationale Anmeldenummer: DE9601299
(87) Internationale Veröffentlichungsnummer: WO9705303

(56) Entgegenhaltungen:
- US-A- 4 753 787
- US-A- 5 026 527
- PATENT ABSTRACTS OF JAPAN vol. 006, no. 114 (C-110), 25.Juni 1982 & JP,A,57 042600 (FUJII TAKASHI;OTHERS: 01), 10.März 1982,

## Beschreibung

Die Erfindung betrifft ein Verfahren zum Herstellen von Siliciumcarbid-Einkristallen.

Zum Herstellen von Siliciumcarbid-Volumeneinkristallen sind Metallschmelzverfahren, Siliciumschmelzverfahren und Züchtungsverfahren über die Gasphase bekannt. Die besten Ergebnisse liefert bislang die Züchtung mittels eines Sublimationsprozesses. Dabei wird Siliciumcarbid (SiC) in fester Form sublimiert und über die Gasphase auf einem Keimkristall als SiC-Einkristall aufgewachsen. Bei einem Sublimationsprozeß sind jedoch Temperaturen von in der Regel über 2000°C zu bewältigen.

Aus *JP-A-57-42600* ist ein Verfahren zur Züchtung von SiC aus einer wäßrigen Lösung bei Raumtemperatur bekannt. Jedoch sind bei diesem bekannten Verfahren die Wachstumsgeschwindigkeiten extrem klein.

Aus *Journal of Crystal Growth, Vol. 53 (1981), Seite 542* ist ein Hydrothermalverfahren zum Züchten von Quarzkristallen bekannt, bei dem Quarz bei Temperaturen zwischen 350°C und 500°C in einem druckfesten Autoklaven in einer KCl- oder NaCl-Lösung gelöst wird und aus der Lösung auf einem Keim auskristallisiert.

Aus *Diamond and Related Materials, Vol. 4 (1995), Seiten 234 bis 235* ist ein Hydrothermalverfahren zum Züchten von Diamantkristallen bekannt, bei dem in einen druckfesten Autoklaven eine spezielle wäßrige Lösung eingefüllt wird und aus der Lösung bei einer Temperatur von 400°C und einem Druck von 170 MPa auf einem Diamant-Keimkristall eine polykristalline Diamantschicht aufgewachsen wird.

Eine Übersicht über weitere bekannte Hydrothermalsynthesen gibt *Angewandte Chemie, Band 97, 1985, Seiten 1017-1032.*

Der Erfindung liegt nun die Aufgabe zugrunde, ein neues Verfahren zum Herstellen von SiC-Einkristallen anzugeben.

Diese Aufgabe wird gemäß der Erfindung gelöst mit den Merkmalen des Anspruchs 1.

Die Erfindung beruht auf der Überlegung, durch Lösen einer festen Ausgangssubstanz in einem Lösungsmittel unter einem ausreichenden Überdruck eine Lösung zu erzeugen, die Silicium und Kohlenstoff enthält, und aus dieser Lösung einen SiC-Einkristall auf einem Keimkristall aufzuwachsen.

Ausgehend von dieser Überlegung werden bei dem Verfahren zum Herstellen von Siliciumcarbid-Einkristallen in einem ersten Verfahrensschritt ein Lösungsmittel, Ausgangsmaterial in fester Form sowie wenigstens ein Keimkristall in einen druckfesten Behälter eingebracht. In einem zweiten Verfahrensschritt wird in dem Behälter ein Druck eingestellt wird, der über 10⁵ Pa (1 bar = ungefähr Normaldruck) liegt und so groß ist, daß das wenigstens eine Ausgangsmaterial wenigstens teilweise im Lösungsmittel gelöst wird. Das Lösungsmittel und das Ausgangsmaterial sind dabei so gewählt, daß die Lösung aus dem Ausgangsmaterial und dem Lösungsmittel sowohl Silicium als auch Kohlenstoff enthält. In einem dritten Verfahrensschritt wird aus der Lösung auf dem wenigstens einen Keimkristall ein Siliciumcarbid-Einkristall aufgewachsen.

Vorteilhafte Ausführungsformen des Verfahrens ergeben sich aus den vom Anspruch 1 abhängigen Ansprüchen.

Demnach kann ein festes Ausgangsmaterial verwendet werden, das nur eines der beiden Elemente Silicium und Kohlenstoff oder auch beide Elemente enthält. Insbesondere kann Siliciumcarbid als Ausgangsmaterial verwendet werden.

Auch das Lösungsmittel kann wenigstens eines der beiden Elemente Silicium und Kohlenstoff enthalten.

Vorzugsweise enthält das Lösungsmittel Wasser (H₂O). Dem Wasser können Elektrolyte (Ionen) zur Steigerung oder Senkung des pH-Werts beigegeben werden, um die Löslichkeit des Ausgangsmaterials im Wasser zu verbessern.

Es kann auch ein Lösungsmittel verwendet werden, das eine Kohlenwasserstoffverbindung enthält.

Zum Dotieren des aufwachsenden Siliciumcarbid-Einkristalls kann in den druckdichten Behälter wenigstens ein Dotierstoff eingebracht werden.

Der Überdruck in dem Behälter wird vorzugsweise durch Zufuhr von Wärme eingestellt. Der Druck in dem Behälter ist dabei abhängig vom zugeführten Wärmestrom und vom Füllungsgrad des Lösungsmittels im Behälter. In einer bevorzugten Ausführungsform liegt der Druck in dem Behälter bei wenigstens etwa 10⁷ Pa (100 bar).

Das feste Ausgangsmaterial wird vorzugsweise auf einer höheren Temperatur gehalten wird als der wenigstens eine Keimkristall. Dadurch stellt sich zwischen dem festen Ausgangsmaterial (Vorrat) und dem Keimkristall ein Temperaturgradient ein. Da die Löslichkeit des Ausgangsmaterials temperaturabhängig ist, entsteht infolge des Temperaturgradienten ein Konzentrationsgefälle des gelösten Ausgangsmaterials in der Lösung zwischen dem Vorrat und dem Keimkristall. Über den Temperaturgradienten kann deshalb die Transportrate (Diffusionsrate) des Ausgangsmaterials vom Vorrat zum Keimkristall eingestellt werden. Durch eine zusätzliche Blendeneinrichtung, beispielsweise ein Gitter, im Behälter kann der Einfluß von Konvektion im Behälter verringert werden und zugleich die Diffusionsrate zwischen Vorrat und Keimkristall zusätzlich eingestellt werden.

In einer weiteren Ausführungsform wird im Lösungsmittel gelöster Sauerstoff zumindest weitgehend entfernt. Dadurch kann eine Oxidation des Silicium und des Kohlenstoffs in der Lösung vermieden werden.

Im folgenden wird die Erfindung anhand von Ausführungsbeispielen näher erläutert.

Es wird ein Behälter (Autoklav) bereitgestellt, der den bei dem Verfahren eingesetzten Drücken standhält, beispielsweise ein Stahlbehälter mit einer entsprechend gewählten Wandstärke. Der Behälter kann insbesondere innen mit Teflon beschichtet sein.

Vorzugsweise in einen unteren Teil dieses druckfesten Gefäßes (Behälters) wird ein Ausgangsmaterial (Vorratsmaterial) in festem Aggregatzustand eingebracht. Das Ausgangsmaterial besteht aus einer oder mehreren Substanzen, die wenigstens eines der beiden Elemente Silicium (Si) oder Kohlenstoff (C) in elementarer Form oder in Form von Verbindungen enthalten. Beispiele für kohlenstoffhaltiges Ausgangsmaterial sind feste Kohlenwasserstoffverbindungen, beispielsweise Paraffine oder Zucker, oder auch Kohlenstoff in elementarer Form. Beispiele für siliciumhaltiges Ausgangsmaterial sind elementares Silicium, Silikate, vorzugsweise Natriumsilikat (NaSiO₄), oder auch Siliciumdioxid. Beispiele für silicium- und kohlenstoffhaltige Ausgangsmaterialien sind Siliciumcarbid (SiC), insbesondere in Form von Sintermaterial, oder eine andere sowohl Silicium als auch Kohlenstoff enthaltende Substanz oder auch ein Gemisch einer kohlenstoffhaltigen Substanz und einer siliciumhaltigen Substanz. Das Ausgangsmaterial wird vorzugsweise wegen der größeren Oberfläche und der damit verbundenen höheren Lösungsgeschwindigkeit in Pulverform gewählt.

Vorzugsweise in einem oberen Teil des Behälters wird wenigstens ein Keimkristall, vorzugsweise ein Siliciumcarbid-Einkristall eines vorgegebenen Polytyps, angeordnet.

Der Behälter wird ferner wenigstens teilweise mit einem im allgemeinen bei Normalbedingungen (Normaldruck, Raumtemperatur) flüssigen Lösungsmittel gefüllt.

Bevorzugtes Lösungsmittel ist Wasser (H₂O) oder ein Gemisch, das Wasser enthält. Vorzugsweise wird destilliertes Wasser verwendet. In einer besonderen Ausführungsform werden dem Wasser zur Veränderung seines pH-Wertes Ionen (Elektrolyte) zugesetzt. Eine Zugabe von Laugen wie beispielsweise NaOH, KOH, NH₄OH oder Mg(OH)₂ macht das Wasser alkalisch (höherer pH-Wert), eine Zugabe von Säuren wie beispielsweise HF, HCl, H₂SO₄ oder HNO₃ oder einer Kombination dieser Säuren, insbesondere der Kombination von HF, H₂SO₄ und HNO₃, dagegen sauer (niedriger pH-Wert). Dadurch kann die Löslichkeit des Ausgangsmaterials im Wasser erhöht werden.

Ein weiteres, geeignetes Lösungsmittel ist Ammoniak (NH₃) in wäßriger Lösung.

Das Lösungsmittel enthält in einer besonderen Ausführungsform selbst Kohlenstoff und/ oder Silicium und kann dann selbst Kohlenstoff- bzw. Siliciumquelle für das Kristallwachstum sein. Als kohlenstoffhaltige Lösungsmittel können beispielsweise unter Normalbedingungen, d.h. bei Normaldruck und Raumtemperatur, flüssige Kohlenwasserstoffverbindungen wie zum Beispiel Alkohole, beispielsweise Methanol oder Ethanol, Ameisensäure oder auch flüssige Alkane wie Hexan verwendet werden.

Nach Einfüllen des Ausgangsmaterials und des Lösungsmittels wird in dem Behälter ein Überdruck, d.h. ein Druck über 1 bar (= 10⁵ Pa), erzeugt, um die Löslichkeit des Ausgangsmaterials im Lösungsmittel zu erhöhen. Der Druck wird vorzugsweise durch Zuführen von Wärme in den Behälter erzeugt, kann aber auch mechanisch durch Zusammenpressen des Lösungsmittels erzeugt werden.

Beim thermischen Erzeugen des Drucks wird das Lösungsmittel im Behälter auf eine vorgegebene Temperatur gebracht. Diese Temperatur ist dabei so gewählt, daß sich ein vorgegebener Druck im Behälter in Abhängigkeit vom Füllungsgrad des Lösungsmittels im Behälter einstellt. Dabei wird ausgenutzt, daß der Druck als Funktion der Temperatur bei gleichbleibendem Volumen des Gefäßes (Isochoren) für unterschiedliche Füllungsgrade des Lösungsmittels eine unterschiedliche Charakteristik aufweist. Je höher der Füllungsgrad des Lösungsmittels, insbesondere des Wassers, im Behälter ist, um so stärker steigt der Druck mit wachsender Temperatur an. Die Temperaturen im Behälter werden im allgemeinen über 100°C und unter etwa 1200°C und vorzugsweise zwischen etwa 150°C und etwa 500°C eingestellt. Der Druck im Behälter wird durch Anpassen des Füllungsgrades des Lösungsmittels im Behälter über 1 bar (10⁵ Pa) und vorzugsweise über 100 bar (10⁷ Pa) eingestellt und wird im allgemeinen 10 kbar (10⁹ Pa) nicht wesentlich überschreiten.

In einer ersten Variante zum thermischen Erzeugen des Drucks wird der druckfeste Behälter in einen Ofen gestellt. In einer zweiten Variante wird dem Behälter dagegen eine eigene Heizung zugeordnet, die beispielsweise als Widerstandsheizung in der Behälterwand integriert sein kann.

Das wenigstens eine Ausgangsmaterial geht in dem nun unter einem Überdruck stehenden Lösungsmittel wesentlich stärker in physikalische und/oder chemische Lösung als bei Normaldruck. Das gelöste Ausgangsmaterial wächst dann durch Auskristallisation gegebenenfalls unter Einbeziehung einer chemischen Reaktion auf dem wenigstens einen Keimkristall als SiC-Volumenkristall auf.

Zum Dotieren des aufwachsenden SiC-Einkristalls kann der Lösung ein gewünschter Dotierstoff beigegeben werden, beispielsweise Bor oder Aluminium für eine p-Dotierung und Stickstoff für eine n-Dotierung. Der Dotierstoff kann eine feste, flüssige oder gasförmige Substanz sein. Zur Stickstoffdotierung sind Ammoniak, Stickstoffgas oder auch eine Aminverbindung geeignet. Ammoniak kann dabei zugleich ein oder der einzige Bestandteil des Lösungsmittels sein. Aluminium und Bor können insbesondere in elementarer Form zugeführt werden.

In einer besonders vorteilhaften Ausführungsform wird der Behälter so erhitzt, daß in seinem unteren Teil mit dem Vorratsmaterial eine höhere Temperatur herrscht als in dem oberen Teil mit dem wenigstens einen Keimkristall. Dadurch stellt sich zwischen Vorrat (festes Ausgangsmaterial) und Keimkristall ein Temperaturgradient ein. Wegen des daraus resultierenden Konzentrationsgefälles des im Wasser gelösten Ausgangsmaterials zwischen Vorrat und Keim und der damit verbundenen Diffusion kann durch diese Maßnahme die Transportrate des Ausgangsmaterials vom Vorrat zum Keimkristall beeinflußt werden.

Außer durch die Einstellung des Temperaturgradienten kann die Transportrate vom Vorrat zum Keim auch durch Einbau eines zusätzlichen Transportreglers, beispielsweise einer Blendeneinrichtung wie einem Gitter (Sieb) und/oder einer Rührvorrichtung in den Autoklaven, gesteuert werden. Durch eine Blendeneinrichtung kann insbesondere auch der unerwünschte Einfluß von Konvektion im Gefäß verringert werden.

Eine höhere Transportrate führt zu einer höheren Wachstumsgeschwindigkeit des SiC-Einkristalls auf dem Keimkristall.

Zur Vermeidung der Oxidation von in der Lösung befindlichem Silicium und Kohlenstoff kann der physikalisch im Lösungsmittel gelöste Sauerstoff vor der Züchtung des SiC-Einkristalls oder schon vor dem Einbringen des Lösungsmittels aus dem Lösungsmittel entfernt werden, beispielsweise durch Auskochen, durch Gasaustausch mit einem Inertgas, durch Absenken des Drucks im Behälter, durch Adsorption oder durch Destillation unter Schutzgas wie z.B. Argon.

In einer weiteren Ausführungsform werden in dem Autoklaven Strömungsleitbleche vorgesehen, die eine insbesondere durch Auftriebskonvektion entstehende Strömung auf den wenigstens einen Keimkristall leiten.

Zur Durchführung des Verfahrens gemäß der Erfindung können prinzipiell auch die aus der eingangs erwähnten Druckschrift *Angewandte Chemie, Band 97, 1985, Seiten 1017-1032* bekannten Vorrichtungen und Autoklaven verwendet werden.

## Patentansprüche

1. Verfahren zum Herstellen von Siliciumcarbid-Einkristallen, bei dem
a) in einen druckfesten Behälter ein Lösungsmittel, Ausgangsmaterial in fester Form sowie wenigstens ein Keimkristall eingebracht werden,
b) in dem Behälter ein Druck eingestellt wird, der über 10⁵ Pa liegt und so groß ist, daß das wenigstens eine Ausgangsmaterial wenigstens teilweise im Lösungsmittel gelöst wird,
c) wobei das Lösungsmittel und das Ausgangsmaterial so gewählt sind, daß die Lösung aus dem Ausgangsmaterial und dem Lösungsmittel sowohl Silicium als auch Kohlenstoff enthält,
und bei dem
c) aus der Lösung auf dem wenigstens einen Keimkristall ein Siliciumcarbid-Einkristall aufwächst.

2. Verfahren nach Anspruch 1, bei dem festes Ausgangsmaterial verwendet wird, das nur eines der beiden Elemente Silicium und Kohlenstoff enthält.

3. Verfahren nach Anspruch 1, bei dem festes Ausgangsmaterial verwendet wird, das sowohl Silicium als auch Kohlenstoff enthält.

4. Verfahren nach Anspruch 3, bei dem als festes Ausgangsmaterial Siliciumcarbid verwendet wird.

5. Verfahren nach einem der vorhergehenden Ansprüche, bei dem ein Lösungsmittel verwendet wird, das wenigstens eines der beiden Elemente Silicium und Kohlenstoff enthält.

6. Verfahren nach einem der vorhergehenden Ansprüche, bei dem das Lösungsmittel Wasser enthält.

7. Verfahren nach Anspruch 6, bei dem durch Zugabe von Elektrolyten der pH-Wert des Wassers verändert wird.

8. Verfahren nach einem der vorhergehenden Ansprüche, bei dem ein Lösungsmittel verwendet wird, das eine Kohlenwasserstoffverbindung enthält.

9. Verfahren nach einem der vorhergehenden Ansprüche, bei dem zum Dotieren des aufwachsenden Siliciumcarbid-Einkristalls in den druckdichten Behälter wenigstens ein Dotierstoff eingebracht wird.

10. Verfahren nach einem der vorhergehenden Ansprüche, bei dem der Druck in dem Behälter durch Zufuhr von Wärme eingestellt wird.

11. Verfahren nach einem der vorhergehenden Ansprüche, bei dem in dem Behälter ein Druck von wenigstens etwa 10⁷ Pa eingestellt wird.

12. Verfahren nach einem der vorhergehenden Ansprüche, bei dem das Ausgangsmaterial auf einer höheren Temperatur gehalten wird als der wenigstens eine Keimkristall.

13. Verfahren nach einem der vorhergehenden Ansprüche, bei dem physikalisch im Lösungsmittel gelöster Sauerstoff aus dem Lösungsmittel zumindest weitgehend entfernt wird.

## Claims

1. Method for producing silicon carbide monocrystals, wherein
a) a solvent, starting material in solid form and at least one seed crystal are introduced into a pressure-resistant container,
b) in the container a pressure is set which is above 10⁵ Pa and is so great that the at least one starting material is dissolved at least partially in the solvent,
c) wherein the solvent and the starting material are selected in such a way that the solution from the starting material and the solvent contains both silicon and carbon,
and wherein
d) a silicon carbide monocrystal grows from the solution on the at least one seed crystal.

2. Method according to claim 1, wherein solid starting material is used, which contains only one of the two elements silicon and carbon.

3. Method according to claim 1, wherein solid starting material is used, which contains both silicon and carbon.

4. Method according to claim 3, wherein silicon carbide is used as solid starting material.

5. Method according to one of the preceding claims, wherein a solvent is used which contains at least one of the two elements silicon and carbon.

6. Method according to one of the preceding claims, wherein the solvent contains water.

7. Method according to claim 6, wherein the pH value of the water is changed by the addition of electrolytes.

8. Method according to one of the preceding claims, wherein a solvent is used which contains a hydrocarbon compound.

9. Method according to one of the preceding claims, wherein at least one doping substance is introduced into the pressure-sealed container for doping the growing silicon carbide monocrystal.

10. Method according to one of the preceding claims, wherein the pressure in the container is set by the supply of heat.

11. Method according to one of the preceding claims, wherein a pressure of at least about 10⁷ Pa is set in the container.

12. Method according to one of the preceding claims, wherein the starting material is kept at a higher temperature than the at least one seed crystal.

13. Method according to one of the preceding claims, wherein oxygen dissolved physically in the solvent is removed at least extensively from the solvent.

## Revendications

1. Procédé de préparation de monocristaux de carbure de silicium, dans lequel
a) on introduit dans un récipient résistant à la pression un solvant, une matière de départ sous forme solide et au moins un germe cristallin,
b) on ajuste dans le récipient une pression supérieure à 10⁵ Pa, et qui est suffisamment grande pour que la ou les matières de départ subissent au moins partiellement une dissolution dans le solvant,
c) le solvant et la matière de départ étant choisis de façon que la solution de la matière de départ et du solvant contiennent tant du silicium que du carbone,
et dans lequel
d) on fait croître un monocristal de carbure de silicium dans la solution, sur le ou les germes cristallins.

2. Procédé selon la revendication 1, dans lequel on utilise une matière de départ solide qui ne contient que l'un des deux éléments silicium et carbone.

3. Procédé selon la revendication 1, dans lequel on utilise une matière de départ qui contient tant du silicium que du carbone.

4. Procédé selon la revendication 3, dans lequel on utilise en tant que matière de départ solide du carbure de silicium.

5. Procédé selon l'une des revendications précédentes, dans lequel on utilise un solvant qui contient au moins l'un des deux éléments silicium et carbone.

6. Procédé selon l'une des revendications précédentes, dans lequel le solvant contient de l'eau.

7. Procédé selon la revendication 6, dans lequel on modifie le pH de l'eau par addition d'électrolytes.

8. Procédé selon l'une des revendications précédentes, dans lequel on utilise un solvant qui contient un composé hydrocarboné.

9. Procédé selon l'une des revendications précédentes, dans lequel, pour doper le monocristal de carbure de silicium en cours de croissance, on introduit au moins un dopant dans le récipient étanche à la pression.

10. Procédé selon l'une des revendications précédentes, dans lequel la pression dans le récipient est ajustée par un apport de chaleur.

11. Procédé selon l'une des revendications précédentes, dans lequel on ajuste dans le récipient une pression d'au moins environ 10⁷ Pa.

12. Procédé selon l'une des revendications précédentes, dans lequel la matière de départ est maintenue à une température plus élevée que le ou les germes cristallins.

13. Procédé selon l'une des revendications précédentes, dans lequel l'oxygène physiquement dissous dans le solvant est au moins presque complètement éliminé du solvant.
